(19)

Europäisches
Patentamt

European
Patent Office

Office européen
des brevets

(11)　**EP 2 479 801 A1**

(12)　**EUROPEAN PATENT APPLICATION**
published in accordance with Art. 153(4) EPC

(43) Date of publication:
　**25.07.2012　Bulletin 2012/30**

(21) Application number: **10817183.6**

(22) Date of filing: **15.09.2010**

(51) Int Cl.:
　*H01L 31/042* (2006.01)　　*B32B 27/36* (2006.01)
　*B32B 27/38* (2006.01)　　*C08J 7/04* (2006.01)
　*C09J 5/00* (2006.01)　　*C09J 7/02* (2006.01)
　*C09J 163/00* (2006.01)　　*C09J 167/00* (2006.01)
　*C09J 175/04* (2006.01)

(86) International application number:
　**PCT/JP2010/065897**

(87) International publication number:
　**WO 2011/034070 (24.03.2011 Gazette 2011/12)**

(84) Designated Contracting States:
　**AL AT BE BG CH CY CZ DE DK EE ES FI FR GB
　GR HR HU IE IS IT LI LT LU LV MC MK MT NL NO
　PL PT RO SE SI SK SM TR**

(30) Priority:　**17.09.2009　JP 2009216282**

(71) Applicant: **Toyo Ink SC Holdings Co., Ltd.
　Tokyo 104-8377 (JP)**

(72) Inventors:
　• **YAMAGUCHI, Hiroshi
　　Chuo-u,
　　Tokyo 104-8377 (JP)**

　• **MASHIMO, Yukifumi
　　Chuo-u,
　　Tokyo 104-8377 (JP)**
　• **YOSHIKAWA, Takeshi
　　Chuo-u,
　　Tokyo 104-8377 (JP)**
　• **MAEDA, Satoshi
　　Chuo-u,
　　Tokyo 104-8377 (JP)**
　• **YAGINUMA, Masaki
　　Chuo-u,
　　Tokyo 104-8377 (JP)**

(74) Representative: **TBK
　Bavariaring 4-6
　80336 München (DE)**

(54)　**PROTECTIVE SHEET FOR THE BACKSIDE OF A SOLAR CELL, MANUFACTURING METHOD THEREFOR, AND SOLAR CELL MODULE**

(57)　Deterioration in electric generating capacity due to acetic acid emitted by the seal layer when hydrolysis occurs can be suppressed. A backside protective sheet (V') for a solar cell includes an adhesive agent layer (1') containing an epoxy resin (A), and a plastic film (2) with one main surface supporting the adhesive agent layer (1').

EP 2 479 801 A1

**Description**

Technical Field

The present invention relates to a backside protective sheet for a solar cell.

Background Art

Recently, awareness of environmental concerns has been increasing, and solar cells attract attention as they are clean energy sources and do not cause environmental pollution. Since the solar cells allow solar energy, which is a substantially inexhaustible energy resource, to be used as electric energy, they have been intensively studied and already put into practical use.

Solar cell elements have various types. As typical solar cell elements, crystalline silicon solar cell elements, polycrystalline silicon solar cell elements, amorphous silicon solar cell elements, copper indium selenide solar cell elements, compound semiconductor solar cell elements, and the like are known. Among these solar cell elements, thin film crystalline solar cell elements, amorphous silicon solar cell elements, and compound semiconductor solar cell elements are relatively inexpensive and can be large-sized. Therefore, research and developments of these solar cell elements are being made enthusiastically. Particularly, thin film solar cell elements typified by amorphous silicon solar cell elements produced by depositing silicon on a conductive metal substrate and further forming a transparent conductive layer on the silicon layer have light-weight and are superior in impact resistance and flexibility. Therefore, these solar cell elements are expected to become a mainstream in the fields of solar cells.

A simple solar cell module has a structure in which a seal layer and a protective member are stacked in this order on each of the front side and back side of a solar cell element.

As the protective member for protecting the light-receiving surface of the solar cell element, a glass plate superior in transparency, weatherability, and scratching resistance has been usually used. As the protective member for protecting the non-receiving surface of the solar cell element, a backside protective sheet for solar cells (hereinafter referred to as a backside protective sheet) is being used in place of a glass plate from the viewpoint of cost, safety and processibility.

Examples of the backside protective sheet include monolayer films such as a polyester film, deposited films obtained by forming a vapor-deposited layer made of a metal oxide or nonmetal oxide on a polyester film, and multilayer films obtained by laminating films such as polyester films, fluoro-films, olefin films, and aluminum foils.

The backside protective sheet having a multilayer structure can have various functions. If, for example, a polyester film is used, a backside protective sheet having excellent insulation property is obtained. When a fluoro-film is used, a backside protective sheet having excellent weatherability is obtained. When an aluminum foil is used, a backside protective sheet superior in water vapor barrier property is obtained. What backside protective sheet to use may be selected properly according to the-type of usage of a solar cell module.

As the seal layer, an ethylene-vinyl acetate copolymer (EVA) film is generally used at present from the viewpoint of transparency and cost.

However, because the EVA film contains vinyl acetate as its structural component as described in Jpn. Pat. Appln. KOKAI Publication Nos. 2005-29588 and 2007-329404, there is the case where EVA is hydrolyzed to produce acetic acid when water vapor or water penetrates at high temperatures. Therefore, a solar cell module using an EVA film as the seal layer has a problem concerning deterioration in the electric generating capacity with time.

The solar cell module using an EVA film as the seal layer also has the problem that the backside protective sheet is easily peeled from the seal layer. In connection to this, Jpn. Pat. Appln. KOKAI Publication No. 2008-108948 describes in the paragraph 0031 and 0033 that a thermally fusible layer which contains, as its major component, at least one of an ethylene-acrylate copolymer, ethylene-methacrylate copolymer and EVA and is further formulated with an epoxy compound, oxazoline compound, or carbodiimide compound is formed on a heat resistant film optionally with an urethane adhesive layer interposed therebetween to constitute a seal protective sheet, that is, a backside protective sheet. Further, in the paragraphs 0027 and 0030 of this literature, there is the description of a solar cell module obtained by applying this backside protective sheet to an EVA film.

Jpn. Pat. Appln. KOKAI Publication No. 2008-108948 discloses in, for example, Table 1 and the paragraph No. 0113 that when a thermally fusible layer obtained by formulating a carbodiimide compound in an ethylene-ethylacrylate copolymer is laminated on a heat resistant film with no urethane adhesive layer interposed therebetween to constitute a backside protective sheet, and this backside protective sheet is thermally fused with an EVA film, delamination is caused between the heat resistant film and the thermally fusible layer in the early stage, that is, before the resulting backside protective sheet is subjected to an accelerated aging test under a high-temperature and high-humidity environment. Further, for example, in Table 1 and the paragraph 0112, there is the description that when the same backside protective sheet as that described above is applied to an EVA film except that this thermally fusible layer is constituted only of an ethylene-ethylacrylate copolymer and is laminated on a heat resistant film through a urethane adhesive layer, a significant reduction in strength is observed in an accelerated aging test under a high-temperature and high-humidity environment though sufficient adhesive strength can be attained in the early stage. From the descriptions in paragraph 0020 of Jpn. Pat. Appln. KOKAI Publication No. 2008-108948, this reason is inferred to be that hydrolysis of the urethane adhesive layer is promoted by acetic acid emitted from the EVA film during the accelerated aging test.

Disclosure of Invention

An object of the present invention is to make it possible to suppress deterioration in electric generating capacity due to acetic acid emitted by the seal layer when hydrolysis occurs.

According to a first aspect of the present invention, there is provided a backside protective sheet (V') for a solar cell, comprising an adhesive agent layer (1') containing an epoxy resin (A), and a plastic film (2) with one main surface supporting the adhesive agent layer (1').

An amount of epoxy group in the adhesive agent layer (1') may be in a range of 0.01 to 5 mmol/g. The adhesive agent layer (1') may further contain a resin (B) other than epoxy resins, the resin (B) having a hydroxyl group and substantially no carboxyl group, and a polyisocyanate compound (C). An epoxy equivalent of the epoxy resin (A) may be 5,000 g/eq or less. The resin (B) may be selected from the group consisting of a polyester resin (B1), an acrylic resin, and a urethane resin. The resin (B) may be the polyester resin (B1). A proportion of the epoxy resin (A) in a total amount of the epoxy resin (A) and the polyester resin (B1) may be in a range of 1 to 50% by mass. The polyester resin (B1) may have a glass transition temperature of 20 to 100°C. The polyisocyanate compound (C) may be a blocked polyisocyanate compound (C1). The backside protective sheet (V') for solar cells may further comprises at least one of a metal foil and a vapor-deposited layer made of a metal oxide or a nonmetal inorganic oxide on a backside of the plastic film (2) that is on a side opposite to the main surface supporting the adhesive agent layer (1').

According to a second aspect of the present invention, there is provided a method of producing a backside protective sheet (V') for solar cells, comprising applying an adhesive agent to a main surface of a plastic film (2) to form an adhesive agent layer (1'), the adhesive agent containing an epoxy resin (A), a resin (B) other than epoxy resins, the resin (B) having a hydroxyl group and substantially no carboxyl group, and a polyisocyanate compound (C).

According to a third aspect of the present invention, there is provided a solar cell module comprising a surface protective member (I), a solar cell element (III) having a light-receiving surface and a non-light-receiving surface, the light-receiving surface facing the surface protective member (I), and a solar cell backside seal sheet (V) including a seal layer (IV) disposed on a non-light-receiving surface's side of the solar cell element (III) and containing an ethylene-vinyl acetate copolymer, and the backside protective sheet (V') for solar cells according to any one of Claims 1 to 10, the solar cell backside seal sheet (V) being obtained by placing the backside protective sheet (V') on the seal layer (IV) such that the adhesive agent layer (1') is in contact with the seal layer (IV).

The solar cell module may further comprises a seal layer (II) containing an ethylene-vinyl acetate copolymer between the surface protective member (I) and the solar cell element (III).

According to the first to third aspects, acetic acid is trapped by the adhesive layer (1) containing the epoxy resin (A) even if acetic acid is produced from the seal layer by hydrolysis. Therefore, deterioration in electric generating capacity due to acetic acid emitted by the seal layer when hydrolysis occurs can be suppressed.

Modes for Carrying Out the Invention Embodiments of the present invention will be described in detail.

A backside protective sheet (V') for a solar cell according to an embodiment of the present invention comprises an adhesive agent layer (1') containing an epoxy resin (A) and a plastic film (2) with one main surface supporting the adhesive agent layer (1'). The backside protective sheet (V') is placed on a seal layer (IV) of a solar cell module, which will be explained later, such that the adhesive agent layer (1') is in contact with the seal layer (IV) containing EVA.

First, the adhesive agent layer (1') will be explained.

The adhesive agent layer (1') is a resin layer installed to improve the adhesion between the plastic film (2) and the seal layer (IV).

An adhesive layer (1) in the solar cell module that corresponds to the adhesive agent layer (1') traps acetic acid produced by hydrolysis occurred in the seal layer (IV). Specifically, the epoxy resin (A) contained in the adhesive layer (1) traps at least a part of acetic acid produced from EVA.

Examples of materials other than the epoxy resin (A) which can trap acetic acid produced from EVA include carbodiimide compounds described in Jpn. Pat. Appln. KOKAI Publication No. 2008-108948. However, because a carbodiimide group has higher reactivity with water than an epoxy group and therefore has difficulty in keeping a trapping function due to the influence of water. If the trapping function is not kept, reduction in the power of a solar cell module cannot be suppressed.

Examples of the epoxy resin (A) include a bisphenol-type epoxy resin, novolac-type epoxy resin, biphenol-type epoxy resin, bixylenol-type epoxy resin, trihydroxyphenylmethane-type epoxy resin, and tetraphenylolethane-type epoxy resin.

Examples of the bisphenol-type epoxy resin include a bisphenol A-type epoxy resin, bisphenol F-type epoxy resin, bisphenol S-type epoxy resin, brominated bisphenol A-type epoxy resin, and hydrogenated bisphenol A-type epoxy resin. It is preferable to use a bisphenol A-type epoxy resin from the viewpoint of cost and solvent solubility.

Examples of the novolac-type epoxy resin include a phenol novolac-type epoxy resin, cresol novolac-type epoxy resin, brominated phenol novolac-type epoxy resin, naphthalene skeleton-containing phenol novolac-type epoxy resin, and dicyclopentadiene skeleton-containing phenol novolac-type epoxy resin.

As the epoxy resin (A), for example, alicyclic epoxy resins such as EHPE-3150 manufactured by Daicel Corporation, heterocyclic epoxy resins such as triglycidylisocyanurate, copolymers of glycidylamines such as N,N,N',N'-tetraglycidylmethaxylenediamine or glycidyl(meth)acrylates and compounds having an ethylenic unsaturated double bond, or epoxy compounds obtained by glycidyl-etherifying a hydroxyl group of a glycol or polyol may be used.

These compounds may be used either independently or in combinations of two or more.

It is to be noted that when a certain functional group is written as "(meth)acryl" in this Description, this means that the functional group may be any of functional groups in which "(meth)acryl" is replaced with "acryl" or with "methacryl". Similarly, in this Description, when a certain compound is written as "(meth)acrylate", this means that the compound may be any of compounds in which "(meth)acrylate" is replaced with "acrylate" or with "methacrylate".

The adhesive agent layer (1') may be installed by various methods. For example, an adhesive may be applied to a plastic film (2) to form a coating layer (1'-a), which may be used as the adhesive agent layer (1'). Alternatively, a film (1'-b) containing a resin which can adhere to an EVA sheet by heating and an epoxy resin (A) may be stacked on a polyester film (2) either directly or through an adhesive agent, and the above resin film (1'-b) may be used as the adhesive agent layer (1'). In the latter case, the adhesive agent layer (1') can be obtained by blending an epoxy resin (A) with, for example, a polyolefin resin such as polyethylene and polypropylene, fluororesin such as polyvinyl fluoride and polyvinylidene fluoride, or ethylene-vinyl acetate copolymer and by forming a film of this mixture using, for example, a T-die extruder.

In this Description and Claims, the amount of an epoxy group contained in the adhesive agent layer (1') is represented by a unit of mmol/g. The description that the amount of an epoxy group in the adhesive agent layer (1') is X mmol means that X mmol of the epoxy group is contained in 1 g of the adhesive agent layer (1') on solid basis.

The amount of the epoxy group in the adhesive agent layer (1') is preferably in a range of 0.01 to 5 mmol/g, more preferably in a range of 0.05 to 2 mmol/g, and even more preferably in a range of 0.1 to 1 mmol/g.

When the amount of the epoxy group is small, the effect of trapping acetic acid is small. When the amount of the epoxy group is large, the content of a component contributing to the adhesion to the seal layer (IV) is relatively small in the adhesive layer (1), so that there is the possibility that the adhesion to the seal layer (IV) is reduced.

Further, in this Description and Claims, the amount of the epoxy group contained in the epoxy resin (A) is expressed by epoxy equivalent. The description that the epoxy equivalent is Y g/eq means that 1 mol of an epoxy group is contained in Y g of the epoxy resin (A). Epoxy group is contained much in a molecule when this epoxy equivalent is smaller.

In the epoxy resin (A), the epoxy equivalent is preferably 5,000 g/eq or less and more preferably 2,000 g/eq or less.

If the value of the epoxy equivalent of the epoxy resin (A) is large, the number average molecular weight of the epoxy resin is inevitably large. An epoxy resin having an excessively large molecular weight has less compatibility with other components. It is therefore difficult to obtain the adhesive agent layer (1') uniformly containing an epoxy resin when an epoxy resin (A) having an excessively large epoxy equivalent is used.

Even if the value of the epoxy equivalent is small, no special disadvantage is observed.

Further, the number average molecular weight (Mn) of the epoxy resin (A) is preferably in a range of 500 to 5,000 and more preferably in a range of 500 to 2,000.

When an epoxy resin having a small number average molecular weight is used as the epoxy resin (A), there is the possibility that a tack, that is, stickiness arises on the surface of the adhesive agent layer (1'). This backside protective sheet (V') typically has a long-length (web) form wound into a roll when it is applied to mass production. Since the backside protective sheet is wound roll-wise, the surface of the adhesive agent layer (1') is in close contact with either the opposite side of the plastic film (2) or an additional layer when the backside protective sheet (V') further contains layers other than the plastic film (2) and adhesive agent layer (1'). Therefore, if the surface of the adhesive agent layer (1') has stickiness, there is the possibility that the layers which are in close contact with each other are blocked, that is, stuck to each other. Further, when the number average molecular weight of the epoxy resin (A) is small, there is the possibility that a solar cell module having excellent durability cannot be obtained.

An epoxy resin (A) having an excessively large number average molecular weight is less compatible with other components as mentioned above, and is therefore undesirable.

When the adhesive agent layer (1') is formed by the coating method, the coating solution preferably contains a resin (B) which is other than epoxy resins and has a hydroxyl group and substantially no carboxyl group, in addition to the epoxy resin (A). It is particularly important that the resin (B) other than epoxy resins contains substantially no carboxyl group. If the resin (B) other than epoxy resins would contain a carboxyl group, the carboxyl group reacts with the epoxy resin (A), resulting in reduced acetic acid-trapping effect of the adhesive layer (1).

The acid value of the resin (B) other than the epoxy resin is preferably 2 mg KOH/g or less and more preferably 1 mg KOH/g or less. If the acid value of the resin (B) having no carboxyl group is large, this organic component reacts with other organic components, that is, the epoxy resin (A) here, which react with a carboxyl group, resulting in reduced acetic acid-trapping effect of the adhesive layer (1).

Further, the hydroxyl value of the resin (B) other than epoxy resins is preferably in a range of 0.1 to 50 mg KOH/g and more preferably in a range of 0.5 to 30 mg KOH/g. If the hydroxyl value is small, the number of reaction sites capable of reacting with a polyisocyanate compound (C), which will be explained later, is small, leading to lower crosslinking density, which deteriorates moisture and heat resistance. If the hydroxyl value is large on the other hand, crosslinking density is increased, so that the adhesive layer (1) after cured is excessively hardened, leading to reduced adhesion to the seal layer.

Examples of the resin (B) other than epoxy resins include polyester resins (B1), urethane resins, and acrylic resins. These resins may be used either singly or in combinations of two or more. Furthermore, materials obtained by compounding these resins may also be used.

Here, "polyester resin (B1)" includes, besides polyester resins obtained by reacting (esterifying reaction or ester exchange reaction) a carboxylic acid component with a hydroxyl group component, polyester-polyurethane resins obtained by reacting an isocyanate compound with a polyester resin having a hydroxyl group, and polyester-polyurethane-polyurea resins obtained by reacting further with a diamine component.

Examples of the carboxylic acid component constituting the polyester resin (B1) include benzoic acid, p-tert-butylbenzoic acid, phthalic acid anhydride, isophthalic acid, terephthalic acid, succinic acid anhydride, adipic acid, azelaic acid, tetrahydrophthalic acid anhydride, hexahydrophthalic acid anhydride, maleic acid anhydride, fumaric acid, itaconic acid, tetrachlorophthalic acid anhydride, 1,4-cyclohexanedicarboxylic acid, trimellitic acid anhydride, methylcyclohexenetricarboxylic acid anhydride, pyromellitic acid anhydride, ε-caprolactone and fatty acids. Methyl esterified products of these carboxylic acid components and lower alcohols such as methanol may also be exemplified as the carboxylic acid components.

Examples of the hydroxyl component constituting the polyester resin (B1) include diol components such as ethylene glycol, propylene glycol, 1,3-butylene glycol, 1,6-hexanediol, diethylene glycol, dipropylene glycol, neopentyl glycol, triethylene glycol, 3-methylpentanediol, and 1,4-cyclohexanedimethanol, and multifunctional alcohols such as glycerin, trimethylol ethane, trimethylol propane, trishydroxymethylaminomethane, pentaerythritol, and dipentaerythritol.

For example, a predetermined polyester resin may be produced by polymerizing the carboxylic acid component and the hydroxyl component using a usual method, and the polyester resin thus produced may be used as the polyester resin (B1).

The urethane resin is a compound obtained by reacting a hydroxyl component other than a polyester resin having a hydroxyl group with an isocyanate compound.

As the hydroxyl component, polymer polyols such as a polyethylene glycol, polypropylene glycol, polyether-type polyols to which ethylene oxide or propylene oxide is added, acryl polyols and polybutadiene-type polyols may be used.

As the isocyanate compound, for example, the same compound as the polyisocyanate compound (C), which will be explained later, may be used. Examples of the isocyanate compound include diisocyanates such as trimethylene diisocyanate (TDI), hexamethylene diisocyanate (HDI), methylenebis(4,1-phenylene)=diisocyanate (MDI), 3-isocyanate methyl-3,5,5-trimethylcyclohexylisocyanate (IPDI), and xylylenediisocyanate (XDI), trimethylolpropane adducts of these diisocyanates, isocyanurates which are trimers of these diisocyanates, biuretized compounds of these diisocyanates, and polymeric diisocyanate.

Further, a urethane urea-type resin obtained by further reacting the urethane resin polymerized in this manner with a diamine component may also be used as one-type of the resin (B) other than epoxy resins. As the diamine component, for example, those which are usually used when producing a urethane urea-type resin may be used.

The acrylic resin can be obtained by polymerizing various acryl-type monomers. Examples of the acryl-type monomer include (meth)acryl-type monomers which have none of a hydroxyl group, glycidyl group and carboxyl group but have an alkyl group, (meth)acryl-type monomers having a hydroxyl group and (meth)acryl-type monomers having a glycidyl group. Besides these acryl-type monomers, for example, vinyl acetate, maleic acid anhydride, vinyl ether, vinyl propionate and styrene may also be used as copolymer monomers.

Examples of the (meth)acryl-type monomers which have none of a hydroxyl group, glycidyl group and carboxyl group but have an alkyl group include methyl(meth)acrylate, ethyl(meth)acrylate, normal butyl(meth)acrylate, 2-ethylhexyl(meth)acrylate, and octyl(meth)acrylate.

Examples of the (meth)acryl-type monomers having a hydroxyl group include 2-hydroxyethyl(meth)acrylate, 2-hydroxypropyl(meth)acrylate, and 4-hydroxybutyl(meth)acrylate.

Examples of the (meth)acryl-type monomers having a glycidyl group include glycidylacrylate, glycidylmethacrylate, and 4-hydroxybutylacrylate glycidyl ether.

Usual radical polymerization may be used to polymerize the above acryl-type monomer. No particular limitation is imposed on the reaction method and a known polymerization method such as solution polymerization, block polymerization and emulsion polymerization may be used. The solution polymerization is preferable because the reaction is easily controlled and this process can be shifted directly to the next operation.

As the solvent, any solvent including methyl ethyl ketone, methyl isobutyl ketone, toluene, cellosolve, ethyl acetate and butyl acetate may be used as long as it can dissolve the above resin. These solvents may be used either singly or in combinations of two or more. As a polymerization initiator to be used in the polymerization reaction, known compounds, for example, organic peroxides such as benzoyl peroxide, acetyl peroxide, methyl ethyl ketone peroxide and lauroyl peroxide, and azo-type initiators such as azobisisobutyronitrile may be used, and no particular limitation is imposed on the polymerization initiator.

The resin (B) other than epoxy resins is preferably a polyester resin (B1) from the viewpoint of adhesion to the plastic film (2) and seal layer.

When the adhesive agent layer (1') is formed using an adhesive containing an epoxy resin (A) and a polyester resin (B1), the ratio occupied by the epoxy resin (A) in the total amount of the epoxy resin (A) and polyester resin (B1) is preferably in a range of 1 to 50% by mass and more preferably in a range of 10 to 40% by mass. When this ratio is small, there is the possibility that the durability of the adhesive layer (1) is dropped and the adhesion to EVA after the adhesive layer is moist-heated is reduced. Further, when the ratio is made large, there is the case where the adhesive layer (1) is hardened and is reduced in adhesion to the seal layer in the early stage.

As the polyester resin (B1), those having a glass transition temperature (Tg) within a range of 20 to 100°C are preferable. If a polyester resin having a lower glass transition temperature is used as the polyester resin (B1), there is the possibility that a tack arises on the surface of the adhesive agent layer (1'), bringing about blocking easily and also the durability is deteriorated. If a polyester resin having a higher glass transition temperature is used as the polyester resin (B1), the solution viscosity of the adhesive becomes high, leading to lower coatability.

The adhesive agent layer (1') may contain or not contain an ethylene-(meth)acrylate copolymer.

Further, the adhesive agent layer (1') may contain EVA though it typically contains no EVA. However, if the adhesive agent layer (1') contains EVA, there is the possibility that acetic acid is generated in the adhesive layer (1). Therefore, in the adhesive agent layer (1'), the proportion of EVA in the total amount of the epoxy resin (A) and resin (B) other than epoxy resins is preferably 50% by mass or less and more preferably 30% by mass or less.

The adhesive agent layer (1') may further contain components other than the resins (A) and (B). In this case, the ratio of the total amount of the epoxy resin (A) and resin (B) other than epoxy resins in the adhesive agent layer (1') is preferably 30% by mass or more, and more preferably 50% by mass or more. If this proportion is small, there is the case where the adhesive strength of the adhesive agent layer (1') to the seal layer may be reduced.

When the adhesive agent layer (1') is formed by the coating method, the adhesive agent preferably contains a curing agent having a functional group which can react with a hydroxyl group besides the epoxy resin (A) and resin (B) other than epoxy resins.

As the curing agent having a functional group which can react with a hydroxyl group, an isocyanate compound is preferable and a polyisocyanate compound (C) is more preferable. An isocyanate group can react with a hydroxyl group in the resin (B) other than epoxy resins to impart moist-heat resistance to the cured adhesive layer (1) and to improve adhesion to the plastic film (2) and the seal layer which constitute the backside protective sheet. It is therefore important that the isocyanate compound has two or more isocyanate groups in one molecule. Examples of the isocyanate compound include aromatic polyisocyanates, chain-type aliphatic polyisocyanates and alicyclic polyisocyanates.

Examples of the aromatic polyisocyanate include 1,3-phenylenediisocyanate, 4,4'-diphenyldiisocyanate, 1,4-phenylenediisocyanate, 4,4'-diphenylmethane diisocyanate, 2,4-tolylenediisocyanate, 2,6-tolylenediisocyanate, 4,4'-toluidine diisocyanate, 2,4,6-triisoicyanate toluene, 1,3,5-triisocyanate benzene, dianisidinediisocyanate, 4,4'-diphenyl ether diisocyanate, and 4,4',4"-triphenylmethane triisocyanate.

Examples of the chain-type aliphatic polyisocyanate include trimethylenediisocyanate, tetramethylenediisocyanate, hexamethylenediisocyanate (HDI), pentamethylenediisocyanate, 1,2-propylenediisocyanate, 2,3-butylenediisocyanate, 1,3-butylenediisocyanate, dodecamethylenediisocyanate, and 2,4,4-trimethylhexamethylenediisocyanate.

Examples of the alicyclic polyisocyanate include 3-isocyanatemethyl-3,5,5-trimethylcyclohexylisocyanate (IPDI), 1,3-cyclopentanediisocyanate, 1,3-cyclohexanediisocyanate, 1,4-cyclohexanediisocyanate, methyl-2,4-cyclohexanediisocyanate, methyl-2,6-cyclohexanediisocyanate, 4,4'-methylenebis(cyclohexylisoicyanate), and 1,4-bis(isocyanatemethyl)cyclohexane.

Further, as the polyisocyanate compound (C), for example, adducts of the above polyisocyanates and polyol compounds such as trimethylolpropane, biuretized compounds or isocyanurated compounds of the above polyisocyanates, or adducts of the above polyisocyanates and a polyether polyol, polyester polyol, acrylpolyol, polybutadiene polyol, polyisoprene polyol, and the like may be used.

Among these polyisocyanate compounds (C), low-yellowing-type aliphatic or alicyclic polyisocyanates are preferable from the viewpoint of resistance to change in color and isocyanurated compounds are preferable from the viewpoint of moist-heat resistance. More specifically, isocyanurated hexamethylenediisocyanate (HDI) and isocyanurated 3-isocyanatemethyl-3,5,5-trimethylcyclohexylisocyanate (IPDI) are preferable.

Moreover, almost all amount of isocyanate groups of the polyisocyanate compound (C) may be reacted with a blocking agent to obtain a blocked polyisocyanate compound (C1). The adhesive agent layer (1') is preferably in a non-crosslinked state before it is applied to the sealing agent to produce a solar cell module. Therefore, the polyisocyanate compound (C) is preferably a blocked polyisocyanate compound (C1).

Examples of the blocking agent include phenols such as phenol, thiophenol, methylthiophenol, xylenol, cresol, resorcinol, nitrophenol, and chlorophenol, oximes such as acetone oxime, methyl ethyl ketone oxime, and cyclohexanone oxime, alcohols such as methanol, ethanol, n-propyl alcohol, isopropyl alcohol, n-butyl alcohol, isobutyl alcohol, t-butyl alcohol, t-pentanol, ethylene glycol monomethyl ether, ethylene glycol monobutyl ether, diethylene glycol monomethyl ether, propylene glycol monomethyl ether and benzyl alcohol, pyrazoles such as 3,5-dimethylpyrazole and 1,2-pyrazole, triazoles such as 1,2,4-triazole, halogen-substituted alcohols such as ethylenechlorohydrin and 1,3-dichloro-2-propanol, lactams such as ε-caprolactam, δ-valerolactam, γ-butyrolactam, and β-propyllactam, and active methylene compounds such as methyl acetoacetate, ethyl acetoacetate, acetylacetone, methyl malonate, and ethyl malonate. Besides the above compounds, amines, imides, mercaptans, imines, ureas, and diaryls are exemplified.

Among these blocking agents, those having a dissociation temperature range of 80 to 150°C are preferable. If the dissociation temperature is low, a curing reaction proceeds when the adhesive agent is applied and a solvent is vaporized, and there is the possibility of unsatisfactory adhesion to the seal layer. If the dissociation temperature is high, the curing reaction insufficiently progresses in the vacuum thermocompression bonding process for producing a solar cell module, and there is therefore the possibility of unsatisfactory adhesion to the seal layer.

Examples of the blocking agent having a dissociation temperature range of 80 to 150°C include methyl ethyl ketone oxime (dissociation temperature: 140°C, the same as follows), 3,5-dimethylpyrazole (120°C) and diisopropylamine (120°C).

The adhesive agent layer (1') is formulated such that the ratio by equivalent of isocyanate groups of the polyisocyanate compound (C) to the total amount of hydroxyl groups of the resin (B) other than epoxy resins is in a range preferably from 1.0 to 15.0 and more preferably from 1.5 to 10.0. If the polyisocyanate compound (C) is small, the reaction with the resin (B) other than epoxy resins makes almost no progress and there is the possibility that the moist-heat resistance of the adhesive layer (1) is insufficient. If the amount of the polyisocyanate compound (C) is large, the cured adhesive layer (1) is excessively hardened and there is the possibility that the initial adhesion to the seal layer is insufficient.

The adhesive agent layer (1') may further contain organic-type particles or inorganic-type particles, which will be described later. When these particles are contained, a tack on the surface of the adhesive agent layer (1') can be reduced. It is preferable to use organic particles having a melting point or softening of 150°C or more. If the melting point or softening point of the organic particles is low, these particles are softened in the vacuum thermocompression process for producing a solar cell module and there is a possibility that bonding with the seal layer is hindered.

Examples of the organic particles or their materials include polymer particles made of polymers such as a polymethylmethacrylate resin, polystyrene resin, nylon resin, melamine resin, guanamine resin, phenol resin, urea resin, silicon resin, methacrylate resin, and acrylate resin, cellulose powder, nitrocellulose powder, wood flour, waste paper powder, chaff powder and starch.

These polymer particles can be obtained by the polymerization methods such as the emulsion polymerization method, suspension polymerization method, dispersion polymerization method, soap-free polymerization method, seed polymerization method and micro-suspension polymerization method. Further, the organic particles may contain impurities to the extent that their characteristics are not impaired. Further, the particles may have any shape or form such as a powder form, particle form, granular form, plate form, and fiber form.

Examples of the inorganic particles include inorganic particles containing an oxide, hydroxide, sulfate, carbonate, or silicate of a metal such as magnesium, calcium, barium, zinc, zirconium, molybdenum, silicon, antimony, or titanium. As the inorganic particles, those containing, for example, silica gel, aluminum oxide, calcium hydroxide, calcium carbonate, magnesium oxide, magnesium hydroxide, magnesium carbonate, zinc oxide, lead oxide, diatomaceous earth, zeolite, aluminosilicate, talc, white carbon, mica, glass fibers, glass powder, glass beads, clay, wollastonite, iron oxide, antimony oxide, titanium oxide, lithopone, pumice powder, aluminum sulfate, zirconium silicate, barium carbonate, dolomite, molybdenum disulfide, iron sand, or carbon black may be used.

The inorganic particles may contain impurities to the extent that their characteristics are not impaired. Further, the inorganic particles may have any shape or form such as a powder form, particle form, granular form, plate form, and fiber form.

The adhesive agent layer (1') contains the above particles in an amount of preferably 0.01 to 30 parts by mass and more preferably 0.1 to 10 parts by mass based on a total of 100 parts by mass of the epoxy resin (A) and resin (B) other than epoxy resins. If the amount of the above particles is small, there is the possibility that a tack on the surface of the adhesive agent layer (1') can be insufficiently reduced. If the amount of the above particles is large, this hinder close contact between the adhesive agent layer (1') and the seal layer, and there is the possibility of deteriorated adhesive strength.

A crosslinking promoter may be added in the adhesive agent layer (1') according to the need to the extent that the effect of the present invention is not impaired. The crosslinking promoter plays a role of a catalyst that promotes the urethane bonding reaction between a hydroxyl group of the resin (B) other than epoxy resins and isocyanate of the polyisocyanate compound (C). Examples of the crosslinking promoter include tin compounds, metal salts and bases. Specific examples of the crosslinking promoter include tin octylate, dibutyltin diacetate, dibutyltin dilaurate, dioctyltin dilaurate, tin chloride, iron octylate, cobalt octylate, zinc naphthenate, triethylamine, and triethylenediamine.

Various additives such as an encapsulant, thixotropy imparting agent, aging preventive, antioxidant, antistatic agent, flame retardant, heat conductive improver, plasticizer, dripping preventive, anti-staining agent, antiseptic, antibacterial agent, antifoaming agent, leveling agent, curing agent, thickener, pigment dispersing agent and silane coupling agent may be added according to the need in the adhesive agent layer (1') to the extent that the effect of the present invention is not impaired.

The thickness of the adhesive agent layer (1') is preferably in a range of 0.01 to 30 $\mu$m and more preferably in a range of 0.1 to 10 $\mu$m.

The adhesive agent layer (1') may be formed by the coating method. In this case, an adhesive containing the epoxy resin (A) is applied to the surface of the plastic film (2) and then, for example, heated to vaporize volatile components such as an organic solvent from the coating film. Here, the step of applying the adhesive and vaporizing a solvent is called coating.

The coating of the adhesive on the plastic film (2) may be carried out by using a conventionally known method. For example, comma coating, gravure coating, reverse coating, roll coating, lip coating, or spray coating may be utilized.

Next, the plastic film (2) will be explained.

As the plastic film (2), for example, a polyester resin film made of a polyester resin such as a polyethylene terephthalate, polybutylene terephthalate, and polyethylene naphthalate, olefin film made of a polyolefin such as a polyethylene, polypropylene, and polycyclopentadiene, fluorine-type film made of a fluororesin such as a polyvinyl fluoride, polyvinylidene fluoride film, polytetrafluoroethylene film, and ethylene-tetrafluoroethylene copolymer film, acryl film, or triacetyl cellulose film may be used. It is preferable to use a polyester resin film and particularly, a polyethylene terephthalate film from the viewpoint of film stiffness and cost.

These films may be used either singly or by laminating two or more. Specifically, the plastic film (2) may have either a monolayer structure or multilayer structure.

The plastic film (2) may be colorless or may contain coloring components such as pigments and dyes. The plastic film (2) containing coloring components is obtained by a method for producing a film from a material into which color components are kneaded or a method for printing color components on a colorless transparent film substrate. Further, a color film and a colorless transparent film may be applied to each other prior to use.

The backside protective sheet for solar cells may be further provided with at least one of a metal foil (3) and a vapor-deposited layer (4) made of a metal oxide or non-metal inorganic oxide on the backside of the plastic film (2) on the side opposite to the primary surface supporting the adhesive agent layer (1') to impart water vapor-barrier characteristics.

As the metal foil (3), for example, an aluminum foil, iron foil, or zinc laminate plate may be used. Among these materials, an aluminum foil is preferable from the viewpoint of corrosion resistance. The thickness of the metal foil (3) is preferably in a range of 10 to 100 $\mu$m and more preferably in a range of 20 to 50 $\mu$m.

The metal foil (3) may be laminated on the plastic film (2) by using an adhesive.

As the metal oxide or nonmetal inorganic oxide, oxides of silicon, aluminum, magnesium, calcium, potassium, tin, sodium, boron, titanium, lead, zirconium, and yttrium may be used. Further, fluorides of alkali metals and alkali earth metals may be used. These compounds may be used either singly or in combinations of two or more.

The metal oxide or nonmetal inorganic oxide may be deposited on the plastic film (2) by PVD (physical vapor deposition) such as vacuum deposition, ion plating and sputtering or CVD (chemical vapor deposition) such as plasma CVD and microwave CVD.

The metal foil (3) and the vapor-deposited layer (4) are preferably formed on the polyester film (2) prior to the formation of the adhesive agent layer (1').

The backside protective sheet for solar cells may further contains a weather proof resin layer (5) that imparts weatherability. The weather proof resin layer (5) is formed in such a manner as to face the adhesive agent layer (1') with the plastic film (2) being sandwiched therebetween. When the backside protective sheet for solar cells contains at least one of the metal foil (3) and vapor-deposited layer (4), the weather proof resin layer (5) is formed in such a manner as to face the plastic film (2) with the metal foil (3) and/or vapor-deposited layer (4) being sandwiched therebetween.

The weather proof resin layer (5) may be formed by applying a polyvinylidene fluoride film and a film made of a polyester resin such as polyethylene terephthalate, polybutylene terephthalate, and polynaphthalene terephthalate, or by applying a highly weather-proof paint such as Lumiflon manufactured by Asahi Glass Co., Ltd. The weather proof resin layer (5) is preferably formed on the polyester film (2) prior to the formation of the adhesive agent layer (1').

Next, a solar cell module will be explained.

A solar cell module according to an embodiment of the present invention includes a surface protective member (I), one or more solar cell elements (III) having a light-receiving surface and a non-light-receiving surface, wherein the light-receiving surface faces the surface protective member (I), a seal layer (IV) which is located on the non-light-receiving surface's side of the solar cell element (III) and contains an ethylene-vinyl acetate copolymer, and a backside seal sheet (V) for solar cells obtained by applying a backside protective sheet (V') for solar cells to the seal layer (IV) in such a manner that the adhesive agent layer (1') is in contact with the seal layer (IV). This solar cell module may further include a seal layer (II) containing an ethylene-vinyl acetate copolymer between the surface protective member (I) and the solar cell element (III).

This solar cell module can be obtained by bringing a surface protective member (I), an optional seal layer (II), a solar cell element (III), a seal layer (IV), and a backside protective sheet (V') for solar cells into contact with each other, for example, under reduced pressure, followed by heating and applying pressure. When the adhesive agent layer (1') is heat-curable, it is further placed under a high-temperature environment after the pressure is returned to ambient pressure to allow the adhesive agent layer (1') to make progress in curing.

When the adhesive agent layer (1') is, for example, heat-curable, the composition of the adhesive agent layer (1') is changed almost simultaneously when the backside protective sheet (V') for solar cells is applied to the seal layer (IV). Therefore, the backside protective sheet (V') for solar cells and adhesive agent layer (1') after they are applied are called a backside seal sheet (V) for solar cells and an adhesive layer (1) respectively to discriminate these sheet and layer from the backside protective sheet (V') for solar cells and adhesive agent layer (1') so-named before they are applied to each other.

As the surface protective member (I), for example, a glass plate or plastic plate such as a polycarbonate plate and polyacrylates plate may be used. A glass plate and particularly, a white plate glass having high transparency are preferable from the viewpoint of transparency, weatherability, and stiffness.

As the seal layers (II) and (IV) located on the light-receiving surface side and non-light-receiving surface side of the solar cell element (III) respectively, a material obtained by molding an ethylene-vinyl acetate copolymer into a sheet form having a thickness of 0.2 mm to 1.0 mm is primarily used. The seal layers (II) and (IV) may further contains additives such as a crosslinking adjuvant and ultraviolet absorber.

Examples of the solar cell element (III) include devices obtained by disposing electrodes in a photoelectric conversion layer made of a compound semiconductor typified by crystalline silicon, polycrystalline silicon, amorphous silicon, or copper indium selenide, or those obtained by laminating each of these devices on a substrate such as glass. The solar cell module may include only one solar cell element (III) or two or more solar cell elements (III).

Examples of the present invention will be described below. In this examples, all designations of "parts" and "%" indicate "parts by weight" and "percent by mass (mass%)", respectively.

<Epoxy resin solution A1>

A bisphenol A-type epoxy resin (trade name: JER1001, manufactured by Japan Epoxy Resin Co., Ltd., epoxy equivalent: 450) was dissolved in ethyl acetate to prepare a resin solution having a solid content of 50%. Hereinafter, this resin solution is called an epoxy resin solution A1.

<Epoxy resin solution A2>

A cresol novolac-type epoxy resin (trade name: YDCN-704, manufactured by Tohto Kasei Co., Ltd., epoxy equivalent: 210) was dissolved in ethyl acetate to prepare a resin solution having a solid content of 50%. Hereinafter, this resin solution is called an epoxy resin solution A2.

<Epoxy resin solution A3>

A polyethylene glycol diglycidyl ether (trade name: Denacol EX-821, manufactured by Nagase chemteX Corporation, epoxy equivalent: 185) was dissolved in ethyl acetate to prepare a resin solution having a solid content of 50%. Hereinafter, this resin solution is called an epoxy resin solution A3.

<Polyester resin solution B1>

A reaction can was charged with 99.6 parts of dimethyl terephthalate, 92.2 parts of ethylene glycol, 72.2 parts of neopentyl glycol, and 0.02 parts of zinc acetate and the mixture was heated to 160 to 210°C in a nitrogen stream with stirring to undergo ester exchange reaction. After methanol was distilled to 97% of the theoretical amount, 77.5 parts of isophthalic acid and 166.9 parts of azelaic acid were charged and the resulting mixture was heated to 160 to 240°C to undergo esterifying reaction. The pressure in the reaction can was gradually reduced to 1 to 2 Torr and the reaction under reduced pressure was stopped when the acid value was dropped down to 0.8 mg KOH/g or less. A polyester polyol having a number average molecular weight of 41,000, a hydroxyl value of 3.2 (mg KOH/g), an acid value of 0.7 (mg KOH/g), and a Tg of -10°C was thus obtained. Moreover, this polyester polyol was diluted with ethyl acetate to obtain a resin solution having a solid content of 50%. Hereinafter, this resin solution is called a polyester resin solution B1.

Here, the number average molecular weight, glass transition temperature Tg, acid value, and hydroxyl value were measured as described below.

<Measurement of the number average molecular weight (Mn)>

GPC (gel permeation chromatography) was used to measure Mn. GPC is liquid chromatography used to quantitatively measure materials dissolved in a solvent (THF: tetrahydrofuran) by a difference in molecular size. The number average molecular weight (Mn) was determined based on polystyrene.

<Measurement of the glass transition temperature (Tg)>

The glass transition temperature was determined by differential scanning calorimetric measurement (DSC).

Specifically, first an aluminum pan charged with about 10 mg of a sample was set to a DSC apparatus. In this case, the same-type of aluminum pan charged with no sample was used as a reference. Next, the sample was heated at 300°C for 5 min, and then, rapidly cooled to -120°C with liquid nitrogen. Then, the sample was heated at a rate of 10°C/min to calculate the glass transition temperature (Tg) of the sample from the obtained DSC chart (unit: °C).

<Measurement of acid value (AV)>

First, about 1 g of the sample (resin solution having a solid content of 50%) was weighed accurately and poured into a conical flask with glass stopper and 100 ml of a toluene-ethanol mixture solution (volume ratio: toluene/ethanol = 2/1) was further added to the sample, which was then mixed. Then, a phenolphthalein reagent was added as an indicator to this solution, which was then kept for 30 sec as it was. Then, the solution was titrated with a 0.1 N alcoholic potassium hydroxide solution until it exhibited rose pink.

The acid value was calculated by the following equation. The acid value was designed to be a value when the resin was dried (unit: mg KOH/g).

```
Acid value (mg KOH/g)

= {(5.611 × a × F)/S}/(Concentration of nonvolatile

components/100)
```

where;

S: amount of the collected sample (g);
a: amount of 0.1 N alcoholic potassium hydroxide solution to be consumed (ml); and
F: titer of 0.1 N alcoholic potassium hydroxide solution.

<Measurement of hydroxyl value (OHV)>

First, about 1 g of the sample (resin solution having a solid content of 50%) was weighed accurately and poured into a conical flask with glass stopper and 100 ml of a toluene-ethanol mixture solution (volume ratio: toluene/ethanol = 2/1) was further added to the sample, which was then mixed. Then, an acetylating agent (solution prepared by dissolving 25 g of acetic acid anhydride in pyridine to be a total of 100 ml) was added in an amount of 5 ml exactly to this solution, which was then stirred for about one hour. A phenolphthalein reagent was added as an indicator to the resulting solution, which was then kept for 30 sec as it was. Then, the solution was titrated with a 0.1 N alcoholic potassium hydroxide solution until it exhibited rose pink.

The hydroxyl value was calculated by the following equation. The hydroxyl value was designed to be a value when the resin was dried (unit: mg KOH/g).

```
Hydroxyl value (mg KOH/g)

= [{(b - a) × F × 28.25}/S]/(Concentration of

nonvolatile components/100) + D
```

where;

S: amount of the collected sample (g);
a: amount of 0.1 N alcoholic potassium hydroxide solution to be consumed (ml);
b: amount of 0.1 N alcoholic potassium hydroxide solution to be consumed in a blank test (ml);
F: titer of 0.1 N alcoholic potassium hydroxide solution; and
D: acid value (mg KOH/g).

<Polyester resin solution B2>

Polyester resin "Vylon 200" (manufactured by Toyobo Co., Ltd., number average molecular weight: 17,000, hydroxyl value: 6 mg KOH/g, acid value: 2 mg KOH/g or less, Tg: 67°C) was dissolved in methyl ethyl ketone to prepare a resin solution having a solid content of 50%. This resin solution is hereinafter called a polyester resin solution B2.

<Polyester resin solution B3>

The polyester resin solutions B1 and B2 were mixed in a ratio by mass of 1 : 1 to prepare a resin infusion solution having a solid content of 50% by weight. This resin solution is hereinafter called a polyester resin solution B3.
The polyester resin in the polyester resin solution B3 had a hydroxyl value of 4.6 mg KOH/g, an acid value of 0.8 mg KOH/g and a Tg of 28°C.

<Polyester resin solution B4>

A reaction can was charged with 117 parts of diethylene glycol, 319 parts of neopentyl glycol, 192 parts of isophthalic acid, 188 parts of terephthalic acid and 214 parts of adipic acid and the mixture was heated to 160 to 240°C in a nitrogen stream with stirring to undergo esterification reaction. The pressure in the reaction can was gradually reduced to 1 to 2 Torr and the reaction under reduced pressure was stopped when the acid value was dropped down to 1 mg KOH/g or less. A polyester resin having a number average molecular weight of 10,000, a hydroxyl value of 19 mg KOH/g, an acid value of 0.9 mg KOH/g, and a Tg of 0°C was thus obtained. Moreover, this polyester resin was diluted with ethyl acetate to obtain a resin solution having a solid content of 50%. Hereinafter, this resin solution is called a polyester resin solution B4.

<Acryl resin solution B5>

A four-neck flask equipped with a cooling tube, stirrer, temperature gauge, and a nitrogen introduction tube was charged with 40 parts of methylmethacrylate, 30 parts of n-butylmethacrylate, 28 parts of 2-ethylhexylmethacrylate, 1 part of 2-hydroxyethylmethacrylate, and 100 parts of toluene and the mixture was heated to 80°C with stirring in a nitrogen atmosphere. 0.15 parts of azobisisobutyronitrile was added to this solution to undergo a polymerization reaction for 2 hr, and in succession, 0.07 parts of azobisisobutyronitrile was added to the reaction mixture to further run a polymerization reaction for 2 hr. Then, 0.07 parts of azobisisobutyronitrile was added to the reaction mixture to further run a polymerization reaction for 2 hr. A resin solution having a number average molecular weight of 25,000, a hydroxyl value of 4.4 mg KOH/g, an acid value of 0 mg KOH/g, a Tg of 39°C and a solid content of 50% was thus obtained. This resin solution is hereinafter called an acryl resin solution B5.

<Urethane resin solution B6>

A reaction can was charged with 140 parts of polycarbonate diol (trade name: UC-100, manufactured by Ube Industries Ltd., number average molecular weight: 1,000), 5 parts of 1,6-hexane diol and 27 parts of isophoronediisocyanate and the mixture was gradually heated to 140 to 160°C with stirring in a nitrogen stream to undergo a urethanation reaction. The reaction was continued at 160°C for 3 hr, and it was confirmed that no NCO peak was found by IR measurement. Then, ethyl acetate was added to the above solution. A resin solution having a number average molecular weight of 35,000, a hydroxyl value of 3.2 mg KOH/g, an acid value of 0 mg KOH/g, a Tg of 30°C and a solid content of 30% was thus obtained. This resin solution is hereinafter called a urethane resin solution B6.

<Curing agent solution>

A trimer of isophoronediisocyanate blocked by methyl ethyl ketone (MEK) oxime and a trimer of hexamethylenediisocyanate blocked by MEK oxime were mixed in a ratio by mass of 1 : 1. The mixture was diluted with ethyl acetate to prepare a resin solution having a solid content of 50%. This resin solution is hereinafter called a curing agent solution.

<Additive D1>

N,N'-dicyclohexylcarbodiimide (functional group equivalent: 206) is called an additive D1.

<Additive D2>

Carbodilite V-07 (trade name, manufactured by Nisshinbo Holdings Inc, functional group equivalent: 200) is called an additive D2.

<Preparation of an adhesive>

The epoxy resin solution (A), the resin solution (B) other than epoxy resins, the additive (D), a curing agent solution, and dibutyltin dilaurate were mixed in the solid content ratio shown in Table 1 to obtain adhesives 1 to 14.

<Adhesive sheet 1>

90 parts by mass of a polypropylene resin (trade name: Prime Polypro F109V, manufactured by Prime Polymer Co., Ltd.) and 10 parts by mass of a bisphenol A-type epoxy resin (trade name: JER 1001, manufactured by Japan Epoxy Resin Co., Ltd., epoxy equivalent: 450) were premixed by a tumbler (trade name: SKS 50, manufactured by Shinei Koki Sangyo). Next, this mixture was subjected to kneading and extrusion using a biaxial extruder (manufactured by Nippon Placon Co., Ltd.). Here, the number of rotations was 300 rpm and the temperature was designed to be 220°C. The resin composition obtained in this manner was pelletized by a pelletizer and then, a resin film (content of epoxy groups: 0.22 mmol/g) 20 $\mu$m in thickness was formed from these pellets by using a T-die extruder kept at a temperature set to 220°C. This resin film is hereinafter called an adhesive sheet 1.

<Adhesive sheet 2>

90 parts by mass of a polyethylene resin (trade name: Neozex 0234N, manufactured by Prime Polymer Co., Ltd.) and 10 parts by mass of a bisphenol A-type epoxy resin (trade name: JER 1001, manufactured by Japan Epoxy Resin Co., Ltd., epoxy equivalent: 450) were premixed by a tumbler (trade name: SKS 50, manufactured by Shinei Koki Sangyo). Next, this mixture was subjected to kneading and extrusion using a biaxial extruder (Nippon Placon Co., Ltd.). Here, the number of rotations was 300 rpm and the temperature was designed to be 220°C. The resin composition obtained in this manner was pelletized by a pelletizer and then, a resin film (content of epoxy groups: 0.22 mmol/g) 20 $\mu$m in thickness was formed from these pellets by using a T-die extruder kept at a temperature set to 220°C. This resin film is hereinafter called an adhesive sheet 2.

<Adhesive sheet 3>

A resin sheet 20 $\mu$m in thickness was formed from a polypropylene resin (trade name: Prime Polypro F109V, manufactured by Prime Polymer Co., Ltd.) by using a T-die extruder kept at a temperature set to 220°C. This resin sheet is hereinafter called an adhesive sheet 3.

<Adhesive sheet 4>

A resin sheet 20 $\mu$m in thickness was formed from a polyethylene resin (trade name: Neozex 0234N, manufactured by Prime Polymer Co., Ltd.) by using a T-die extruder kept at a temperature set to 220°C. This resin sheet is hereinafter called an adhesive sheet 4.

(Examples 1 to 9 and Comparative Examples 1 to 5)

Using each of the adhesives 1 to 14, the adhesion strength (initial stage and after moist-heat treatment) between the polyester film and the EVA sheet and the amount of acetic acid to be generated from the EVA sheet was measured as described below. The results are shown in Table 2.

(Measurement of adhesion strength)

The adhesives 1 to 14 were each applied to the corona-treated surface of a polyester film (trade name: Lumirror X-10S, thickness: 50 $\mu$m, manufactured by Toray industries, Inc.) by using a Mayer bar coater and a solvent was vaporized to form an adhesive agent layer (1') on the polyester film. Here, the amount of the adhesive to be applied was set to 2 g/m$^2$ on solid basis.

Two polyester films were prepared which were each the same as the polyester film with the adhesive agent layer (1') and laminated such that the adhesive agent layer (1') sides are facing each other with the EVA sheet being interposed therebetween. Here, an EVA sheet (thickness: 450 $\mu$m, standard cure type) manufactured by Sanvic Inc. was used as the EVA sheet. In succession, heat and pressure were applied to this laminate to pressure-bond the polyester film with the adhesive agent layers (1') with the EVA sheet. A vacuum laminator was used to apply heat and pressure. Here, the process was carried out in the following condition: temperature: 150°C, deaerating time: 5 min, press pressure: 1 atm, and press time: 10 min. Further, the temperature and time for after-curing were set to 150°C and 15 min respectively. A sample for measurement of adhesion strength was produced in the above manner.

With regard to a part of the samples for measurement of adhesion strength obtained in this manner, a pressure cooker test (hereinafter referred to as PCT) was made in the following condition: temperature: 121°C, relative humidity: 100% RH, pressure: 2 atom, and test time: 48 hr.

The samples (initial stage) which were not subjected to PCT and the samples which were subjected to PCT (after subjected to moist-heat process) were each cut into a rectangular form 15 mm in width to make test specimens. Each test specimen was subjected to a T-character peeling test using a tension tester. Here, the rate of loading was set to 100 mm/min. The evaluation standard for the T-character peeling test is described below.

O: 20 N/15 mm or more
Δ: 5 N/15 mm or more and less than 20 N/15 mm
x: less than 5 N/15 mm

(Method of evaluation of the amount of acetic acid to be produced)

<Preparation of a polyester film (2)>

Each surface of a polyester film (trade name: Tetoron S, manufactured by Teijin DuPont Films Japan Limited, thickness: 188 $\mu$m) was corona-treated. An adhesive (trade name: "Dinareo VA-3020/HD-701", manufactured by Toyo Ink Holdings Company, Limited, compounding ratio: 100/7) was applied to one surface of the polyester film by a gravure coater and the coating film was then dried to form an adhesive agent layer. Here, the amount of the adhesive to be applied was designed to be 10 g/m$^2$ on solid basis.

Then, the deposition surface of a deposited film was overlapped on the adhesive agent layer. Here, as the deposited film, a PET film (trade name: Teck Barrier LX, manufactured by Mitsubishi Plastics Inc., thickness: 12 $\mu$m) with one deposited surface which was prepared by forming a vapor-deposited layer of silicon oxide on one surface of a polyethylene terephthalate (PET) film and by corona-treating the other surface was used.

After that, the resulting product was aged at 50°C over 4 days to cure the adhesive agent layer, thereby obtaining a polyester film (2) for evaluation.

<Production of backside protective sheets 1 to 14>

An adhesive was applied to the corona-treated surface of the one-surface-deposited PET film of the polyester film (2) for evaluation by a Mayer bar coater and a solvent was vaporized to form an adhesive agent layer (1'). Here, the amount of the adhesive to be applied was 2 g/m$^2$ on solid basis. The adhesives 1 to 14 were respectively used as the adhesive in this manner to form backside protective sheets 1 to 14 for evaluation.

<Production of a pseudo module for evaluation>

A glass plate, the same EVA sheet as that used to manufacture the sample for measurement of adhesion strength, and each of the backside protective sheets 1 to 14 were laminated such that the surface on the adhesive agent layer (1') side of the backside protective sheet was facing the glass plate with the EVA sheet being interposed therebetween. In succession, heat and pressure were applied to this laminate to bind the glass plate, EVA sheet, and backside protective sheet by pressure bonding. A vacuum laminator was used to apply heat and pressure. Here, the process was carried out in the following condition: temperature: 150°C, deaerating time: 5 min, press pressure: 1 atm, and press time: 10 min. Further, the temperature and time for after-curing were set to 150°C and 15 min respectively. Pseudo-modules 1 to 14 for evaluation were produced using the backside protective sheets 1 to 14 respectively in the above manner.

<Promotion of hydrolysis of the EVA sheet>

Each of the pseudo-modules 1 to 14 for evaluation was subjected to PCT made for 48 hr and PCT made for 96 hr in the condition of a temperature of 121°C, a relative humidity of 100% RH and a pressure of 2 atm to promote hydrolysis of the EVA sheet.

<Measurement of the amount of acetic acid to be generated>

(1) With regard to each of the pseudo modules for evaluation which had been subjected to PCTs made for 48 hr and 96 hr, the glass plate and protective sheet were peeled from the EVA sheet.
(2) With regard to each of the EVA sheets from which the glass plate and protective sheet were peeled, a test specimen having 1.5 cm × 1.5 cm square form was cut from the center (part 3 cm or more apart from the periphery) thereof. The mass X of each test specimen was measured and then, the specimen was dipped in a predetermined amount Y (about 4 g) of water. In succession, a container containing the test specimen and water was tightly closed and allowed to stand overnight to extract acetic acid generated in the EVA sheet with water by promotion of hydrolysis.
(3) With regard to the extraction water obtained in the procedure (2), the concentration Z of acetic acid was found by ion chromatography.
(4) The concentration Z ($\mu$g/g) of acetic acid found by the procedure (3) was multiplied by the amount Y (g) of the water utilized for extraction, and the product was divided by the mass X (g) of the test specimen to calculate the amount ($\mu$g/g) of acetic acid to be generated per 1 g of EVA. This calculation formula is shown below.

$$\text{(Amount [\mu g/g] of acetic acid to be generated per 1 g of EVA)} = Z\ [\mu g/g] \times Y\ [g]/X\ [g]$$

(Examples 10 and 11, and Comparative Examples 6 and 7)

Backside protective sheets 15 to 18 for evaluation were respectively formed in the same method as that explained in the backside protective sheets 1 to 14 for evaluation except that adhesive sheets 1 to 4 were respectively applied to a polyester film (2) for evaluation through an adhesive ("trade name: "Dinareo VA-3020/HD-701", manufactured by Toyo Ink Holdings Company, Limited, compounding ratio: 100/7) instead of applying the adhesives 1 to 14 to the polyester film (2) for evaluation. Then, pseudo-modules 15 to 18 for evaluation were respectively formed in the same method as that explained about the pseudo-modules 1 to 14 for evaluation except that the backside protective sheets 15 to 18 were respectively used in place of the backside protective sheets 1 to 14. Then, these pseudo modules 5 to 18 for evaluation were measured according to the above <Promotion of hydrolysis of the EVA sheet> and <Measurement of the amount of acetic acid to be generated> which were mentioned for the pseudo-modules 1 to 14 for evaluation.

(Comparative Example 8)

A pseudo-module 19 for evaluation was produced in the same method as that explained about the pseudo-modules 1 to 14 for evaluation except that the polyester film (2) for evaluation which was coated with no adhesive was used as the backside protective sheet 19 in place of the backside protective sheets 1 to 14. Then, the pseudo module 19 for evaluation was measured according to the above <Promotion of hydrolysis of the EVA sheet> and <Measurement of the amount of acetic acid to be generated> which were mentioned for the pseudo-modules 1 to 14 for evaluation.

The results are described collectively in Table 2.

TABLE 1

| | | | | Adhesive | | | | | | | | | | | | | | |
|---|---|---|---|---|---|---|---|---|---|---|---|---|---|---|---|---|---|---|
| Epoxy resin solution (A) | | Epoxy equivalent (g/eq) | | 1 | 2 | 3 | 4 | 5 | 6 | 7 | 8 | 9 | 10 | 11 | 12 | 13 | 14 |
| | A1: Bisphenol A-type epoxy resin | 450 | | 15 | 30 | | | 15 | 15 | 15 | 15 | 15 | | | | | |
| | A2: Cresol novolac type epoxy resin | 210 | | | | 7 | | | | | | | | | | | |
| | A3: Polyethylene glycol glycidyl ether | 185 | | | | | 7 | | | | | | | | | | |
| Solution (B) of a resin other than epoxy resins | | Tg | OHV | AV | | | | | | | | | | | | | |
| | Polyester resin B1 | -10 | 3.2 | 0.7 | | | | | | | | 85 | | | | | | |
| | Polyester resin B2 | 67 | 6 | 2 | | | | | 85 | | | | | | | | | |
| | Polyester resin B3 | 28 | 4.6 | 0.8 | 85 | 70 | 93 | 93 | | | | | | 100 | 93 | 93 | | |
| | Polyester resin B4 | 0 | 19 | 0.9 | | | | | | | | | 85 | | | | | |
| | Acrylic resin B5 | 39 | 4.4 | 0 | | | | | | 85 | | | | | | | 100 | |
| | Urethane resin B6 | 30 | 3.2 | 0 | | | | | | | 85 | | | | | | | 100 |
| Additives (D) | | Carbodiimide group equivalent (g/eq) | | | | | | | | | | | | | | | |
| | D1: N,N'-dicyclohexylcarbodiimide | 206 | | | | | | | | | | | | 7 | | | |
| | D2: Carbodilite V-07 | 200 | | | | | | | | | | | | | 7 | | |
| Curing agent solution | | | | 15 | 15 | 15 | 15 | 15 | 15 | 15 | 15 | 15 | 15 | 15 | 15 | 15 | 15 |
| Dibutyltin dilaurate | | | | 0.25 | 0.25 | 0.25 | 0.25 | 0.25 | 0.25 | 0.25 | 0.25 | 0.25 | 0.25 | 0.25 | 0.25 | 0.25 | 0.25 |
| Amount of epoxy (or carbodiimide) groups in an adhesive on solid basis (mmol/g) | | | | 0.28 | 0.56 | 0.28 | 0.33 | 0.28 | 0.28 | 0.28 | 0.28 | 0.28 | 0 | 0.29 | 0.30 | 0 | 0 |

TABLE 2

| | | Backside protective sheet | Adhesive agent or adhesive sheet | Amount of epoxy (or carbodiimide) group (mmol/g) | Adhesion strength | | Amount of acetic acid generated ($\mu$g/g) | |
|---|---|---|---|---|---|---|---|---|
| | | | | | Initial stage | After PCT 121°C × 48h | After PCT 121°C × 48h | After PCT 121°C × 96h |
| Example | 1 | 1 | Adhesive 1 | 0.28 | O | O | 76 | 151 |
| | 2 | 2 | Adhesive 2 | 0.56 | O | O | 56 | 110 |
| | 3 | 3 | Adhesive 3 | 0.28 | O | O | 69 | 140 |
| | 4 | 4 | Adhesive 4 | 0.33 | O | O | 65 | 129 |
| | 5 | 5 | Adhesive 5 | 0.28 | O | O | 67 | 140 |
| | 6 | 6 | Adhesive 6 | 0.28 | O | O | 71 | 144 |
| | 7 | 7 | Adhesive 7 | 0.28 | O | O | 78 | 122 |
| | 8 | 8 | Adhesive 8 | 0.28 | O | × | 66 | 138 |
| | 9 | 9 | Adhesive 9 | 0.28 | O | × | 75 | 140 |
| | 10 | 15 | Adhesive sheet 1 | 0.22 | O | O | 80 | 135 |
| | 11 | 16 | Adhesive sheet 2 | 0.22 | O | O | 73 | 131 |
| Comparative Example | 1 | 10 | Adhesive 10 | 0 | O | × | 95 | 237 |
| | 2 | 11 | Adhesive 11 | 0.29 | O | O | 73 | 214 |
| | 3 | 12 | Adhesive 12 | 0.3 | O | O | 64 | 207 |
| | 4 | 13 | Adhesive 13 | 0 | O | O | 115 | 246 |
| | 5 | 14 | Adhesive 14 | 0 | O | O | 107 | 225 |
| | 6 | 17 | Adhesive sheet 3 | 0 | O | O | 92 | 239 |
| | 7 | 18 | Adhesive sheet 4 | 0 | O | O | 101 | 228 |
| | 8 | 19 | None | — | O | × | 91 | 243 |

As shown in Table 2, each of Examples 1 to 11 was more reduced in the amount of acetic acid to be produced than each of Comparative Examples 1 and 4 to 7 in which the adhesive agent layer contained no epoxy resin and Comparative 8 containing no adhesive agent layer. Further, as is clear from the data of Table 2, the amount of acetic acid was more reduced when the adhesive agent layer (1') containing a larger amount of epoxy groups was used. From the above facts, it is found that the adhesive layer (1) containing an epoxy resin traps acetic acid produced by hydrolysis of EVA and the ability to trap acetic acid in the adhesive layer (1) containing the epoxy resin depends on the amount of epoxy groups.

In Comparative Examples 2 and 3, the adhesive agent layer (1) contained carbodiimide which can react with acetic acid and therefore, the amount of acetic acid to be generated after PCT made at 121°C for 48 hr was small similarly to the case of Examples 1 to 11. In Comparative Examples 2 and 3, however, a large amount of acetic acid was detected after PCT made at 121°C for 96 hr. This reason is inferred to be that because a carbodiimide group was reactively more active than an epoxy group, so that the carbodiimide group reacted with water during PCT, and therefore, the ability to trap acetic acid was deteriorated.

It is to be noted that, in Examples 8 and 9, the amount of acetic acid to be generated was small similarly to the case of other examples and also, sufficient adhesion strength was developed in the initial stage. In Examples 8 and 9, however, adhesion strength was deteriorated after the moist-heat process. This reason is that the resin (B) used in Examples 8 and 9 had a low glass transition temperature.

(Example 12)

<Production of a solar cell module>

A seal layer (II), a solar cell element (III), a seal layer (IV), and a backside protective sheet (V') were laminated in this order on a surface protective member (I). Here, a white plate glass was used as the surface protective member (I), EVA sheets were used as the seal layers (II) and (IV), and a polycrystalline silicon solar cell element was used as the solar cell element (III). As the backside protective sheet (V'), the above backside protective sheet 1 was used. The backside protective sheet (V') was disposed such that the adhesive agent layer (1') was in contact with the seal layer (IV).

In succession, heat and pressure were applied to this laminate to pressure-bond these elements on each other. A vacuum laminator was used to apply heat and pressure. Here, the process was carried out in the following condition: temperature: 150°C, deaerating time: 5 min, press pressure: 1 atm, and press time: 15 min. Further, the temperature and time for after-curing were set to 150°C and 30 min respectively. A solar cell module 1 for evaluation of photoelectric conversion efficiency which had a dimension of 10 cm x 10 cm was produced in the above manner.

<Measurement of photoelectric conversion efficiency>

The solar cell output of the solar cell module 1 was measured to measure photoelectric conversion efficiency by using a solar simulator (trade name: SS-100XIL, manufactured by Eko Instruments Co., Ltd.) according to Japanese Industrial Standard JIS C8912.

Moreover, the photoelectric conversion efficiency of the solar cell module 1 when the solar cell module was allowed to stand at 85°C under a relative humidity of 85% RH for 500 hr was measured, and also, the photoelectric conversion efficiency of the solar cell module 1 when the solar cell module was allowed to stand in the same condition for 1,000 hr, 1,500 hr, and 2,000 hr was measured in the same method. The ratio of a reduction in photoelectric conversion efficiency caused by the moist-heat resistance test to the photoelectric conversion efficiency in the initial stage was calculated to evaluate based on the following standard.

O: Reduction in output is less than 10%
Δ : Reduction in output is 10% or more and less than 20%
✕ : Reduction in output is 20% or more.

(Examples 13 to 18 and Comparative Examples 9 to 13)

Solar cell modules 2, 3, 6, 7, 10 to 12, and 15 to 18 were formed in the same method as that explained for the solar cell module 1 except that the backside protective sheets 2, 3, 6, 7, 10 to 12, and 15 to 18 were respectively used in place of the backside protective sheet 1. Then, each of these solar cell modules 2, 3, 6, 7, 10 to 12, and 15 to 18 was measured according to the aforementioned <Measurement of photoelectric conversion efficiency> mentioned for the solar cell module 1.

(Comparative Example 14)

A solar cell module 19 was formed in the same method as that explained for the solar cell module 1 except that the backside protective sheet 19 was used in place of the backside protective sheet 1 and the laminate was formed such that the corona-treated surface of one-surface-deposited PET film of the backside protective sheet 19 was in contact with the seal layer (IV). Then, the solar cell module 19 was measured according to the aforementioned <Measurement of photoelectric conversion efficiency> mentioned for the solar cell module 1.

(Example 19)

One surface of a polyester film (trade name: Tetoron S, manufactured by Teijin DuPont Films Japan Limited, thickness: 188 $\mu$m) was corona-treated. The adhesive 1 was applied to the corona-treated surface of the polyester film by Mayer bar coater and a solvent was vaporized to form an adhesive agent layer (1') on the polyester film. Here, the amount of the adhesive to be applied was designed to be 2 g/m$^2$ on solid basis. A backside protective sheet 20 for evaluation was obtained in this manner.
A solar cell module 20 was formed in the same method as that explained for the solar cell module 1 except that the backside protective sheet 20 was used in place of the backside protective sheet 1. Then, the solar cell module 20 was measured according to the aforementioned <Measurement of photoelectric conversion efficiency> mentioned for the solar cell module 1.

(Comparative Example 15)

A backside protective sheet 21 for evaluation was obtained in the same method as that explained for the backside protective sheet 20 except that the adhesive agent 10 was used as the adhesive agent 1. Then, a solar cell module 21 was formed in the same method as that explained for the solar cell module 1 except that the backside protective sheet 21 was used in place of the backside protective sheet 1. Then, the solar cell module 21 was measured according to the aforementioned <Measurement of photoelectric conversion efficiency> mentioned for the solar cell module 1.
The results are shown collectively in Table 3.

TABLE 3: Solar cell module

| | Solar cell module | Solar cell backside protective sheet | Adhesive agent or adhesive sheet | Amount of an epoxy group or carbodiimide group in adhesive agent (mmol/g) | Reduction in output after moist-heat resistance test | | | |
|---|---|---|---|---|---|---|---|---|
| | | | | | Moist-heat resistance test (85°C × 85%) | | | |
| | | | | | After 500 hr | After 1,000 hr | After 1,500 hr | After 2,000 hr |
| Example 12 | 1 | 1 | Adhesive 1 | 0.28 | ○ | ○ | ○ | ○ |
| Example 13 | 2 | 2 | Adhesive 2 | 0.56 | ○ | ○ | ○ | ○ |
| Example 14 | 3 | 3 | Adhesive 3 | 0.28 | ○ | ○ | ○ | ○ |
| Example 15 | 4 | 6 | Adhesive 6 | 0.28 | ○ | ○ | ○ | ○ |
| Example 16 | 5 | 7 | Adhesive 7 | 0.28 | ○ | ○ | ○ | ○ |
| Example 17 | 6 | 15 | Adhesive sheet 1 | 0.22 | ○ | ○ | ○ | ○ |
| Example 18 | 7 | 16 | Adhesive sheet 2 | 0.22 | ○ | ○ | ○ | ○ |
| Example 19 | 8 | 20 | Adhesive 1 | 0.28 | ○ | ○ | △ | △ |
| Comparative Example 9 | 9 | 10 | Adhesive 10 | 0 | △ | △ | × | × |
| Comparative Example 10 | 10 | 11 | Adhesive 11 | 0.29 | ○ | ○ | △ | × |
| Comparative Example 11 | 11 | 12 | Adhesive 12 | 0.30 | ○ | ○ | △ | × |
| Comparative Example 12 | 12 | 17 | Adhesive sheet 3 | 0 | ○ | △ | △ | × |
| Comparative Example 13 | 13 | 18 | Adhesive sheet 4 | 0 | △ | △ | × | × |
| Comparative Example 14 | 14 | 19 | None | – | △ | × | × | × |
| Comparative Example 15 | 15 | 21 | Adhesive 10 | 0 | △ | × | × | × |

In the case of Examples 12 to 19, as shown in Table 3, reduction in the output of the solar cell module caused by the moist-heat test could be suppressed. In the case of Comparative Examples 9 and 12 to 14, on the other hand, the output of the solar cell module was significantly reduced in a relatively short time by the moist-heat test. From these results, it is found that the adhesive layer (1) obtained from the adhesive agent layer (1') containing the epoxy resin (A) traps acid generated from EVA to thereby restrain the deterioration of the solar cell module caused by water.

Example 19 has not so large effect on limitation to reduction in the output of the solar cell module caused by the moist-heat test as compared with Examples 12 to 18, though it is more limited in reduction of the output of the solar cell module caused by the moist-heat test as compared with Comparative Examples 9 and 12 to 14. This reason is that the backside protective sheet 20 used in Example 19 has no water-vapor barrier characteristics.

Further, Comparative Examples 10 and 11 do not produce so large effect on limitation to reduction in the output of the solar cell module caused by the moist-heat test as compared with Examples 12 to 19, though it is more limited in reduction of the output of the solar cell module caused by the moist-heat test as compared with Comparative Examples 9 and 12 to 14. This reason is inferred to be that the solar cell modules 10 and 11 according to Comparative Examples 10 and 11 were reduced in acetic acid-trapping effect because carbodiimide gradually reacts with water in the moist-heat test.

**Claims**

1. A backside protective sheet (V') for a solar cell, comprising:

    an adhesive agent layer (1') containing an epoxy resin (A); and
    a plastic film (2) with one main surface supporting the adhesive agent layer (1').

2. The backside protective sheet (V') for solar cells according to claim 1, wherein an amount of epoxy group in the adhesive agent layer (1') is in a range of 0.01 to 5 mmol/g.

3. The backside protective sheet (V') for solar cells according to claim 1 or 2, wherein the adhesive agent layer (1') further contains a resin (B) other than epoxy resins, the resin (B) having a hydroxyl group and substantially no carboxyl group, and a polyisocyanate compound (C).

4. The backside protective sheet (IV') for solar cells according to claim 3, wherein an epoxy equivalent of the epoxy resin (A) is 5,000 g/eq or less.

5. The backside protective sheet (V') for solar cells according to claim 3 or 4, wherein the resin (B) is selected from the group consisting of a polyester resin (B1), an acrylic resin, and a urethane resin.

6. The backside protective sheet (V') for solar cells according to claim 5, wherein the resin (B) is the polyester resin (B1).

7. The backside protective sheet (V') for solar cells according to claim 6, wherein a proportion of the epoxy resin (A) in a total amount of the epoxy resin (A) and the polyester resin (B1) is in a range of 1 to 50% by mass.

8. The backside protective sheet (V') for solar cells according to claim 6 or 7, wherein the polyester resin (B1) has a glass transition temperature of 20 to 100°C.

9. The backside protective sheet (V') for solar cells according to any one of claims 3 to 8, wherein the polyisocyanate compound (C) is a blocked polyisocyanate compound (C1).

10. The backside protective sheet (V') for solar cells according to any one of claims 1 to 9, further comprising at least one of a metal foil and a vapor-deposited layer made of a metal oxide or a nonmetal inorganic oxide on a backside of the plastic film (2) that is on a side opposite to the main surface supporting the adhesive agent layer (1').

11. A method of producing a backside protective sheet (V') for solar cells, comprising:

    applying an adhesive agent to a main surface of a plastic film (2) to form an adhesive agent layer (1'), the adhesive agent containing an epoxy resin (A), a resin (B) other than epoxy resins, the resin (B) having a hydroxyl group and substantially no carboxyl group, and a polyisocyanate compound (C).

12. A solar cell module comprising:

    a surface protective member (I);

a solar cell element (III) having a light-receiving surface and a non-light-receiving surface, the light-receiving surface facing the surface protective member (I); and

a solar cell backside seal sheet (V) including a seal layer (IV) disposed on a non-light-receiving surface's side of the solar cell element (III) and containing an ethylene-vinyl acetate copolymer, and the backside protective sheet (V') for solar cells according to any one of Claims 1 to 10, the solar cell backside seal sheet (V) being obtained by placing the backside protective sheet (V') on the seal layer (IV) such that the adhesive agent layer (1') is in contact with the seal layer (IV).

13. The solar cell module according to claim 12, further comprising a seal layer (II) containing an ethylene-vinyl acetate copolymer between the surface protective member (I) and the solar cell element (III).

<table>
<tr><td colspan="2"><strong>INTERNATIONAL SEARCH REPORT</strong></td><td>International application No.<br>PCT/JP2010/065897</td></tr>
</table>

A. CLASSIFICATION OF SUBJECT MATTER
*H01L31/042*(2006.01)i, *B32B27/36*(2006.01)i, *B32B27/38*(2006.01)i, *C08J7/04*
(2006.01)i, *C09J5/00*(2006.01)i, *C09J7/02*(2006.01)i, *C09J163/00*(2006.01)i,
*C09J167/00*(2006.01)i, *C09J175/04*(2006.01)i
According to International Patent Classification (IPC) or to both national classification and IPC

B. FIELDS SEARCHED

Minimum documentation searched (classification system followed by classification symbols)
H01L31/042, B32B27/36, B32B27/38, C08J7/04, C09J5/00, C09J7/02,
C09J163/00, C09J167/00, C09J175/04

Documentation searched other than minimum documentation to the extent that such documents are included in the fields searched
Jitsuyo Shinan Koho        1922-1996    Jitsuyo Shinan Toroku Koho    1996-2010
Kokai Jitsuyo Shinan Koho  1971-2010    Toroku Jitsuyo Shinan Koho    1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2008-108948 A (Toppan Printing Co., Ltd.),<br>08 May 2008 (08.05.2008),<br>paragraphs [0027], [0043], [0054], [0070],<br>[0076], [0081] to [0082]; fig. 1 to 2<br>(Family: none) | 1-8,10-13 |
| X | JP 2008-4691 A (Toppan Printing Co., Ltd.),<br>10 January 2008 (10.01.2008),<br>paragraphs [0010], [0015], [0032]<br>& EP 2040306 A1        & WO 2007/148754 A1<br>& CA 2658010 A | 1-11 |

☐ Further documents are listed in the continuation of Box C.    ☐ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search<br>    25 October, 2010 (25.10.10) | Date of mailing of the international search report<br>    02 November, 2010 (02.11.10) |
|---|---|
| Name and mailing address of the ISA/<br>    Japanese Patent Office | Authorized officer |
| Facsimile No. | Telephone No. |

Form PCT/ISA/210 (second sheet) (July 2009)

**EP 2 479 801 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005029588 A
- JP 2007329404 A
- JP 2008108948 A